# EUROPÄISCHE PATENTSCHRIFT

(11) **EP 3 488 128 B1**
(45) Veröffentlichungstag und Bekanntmachung des Hinweises auf die Patenterteilung: **01.01.2020**
(21) Anmeldenummer: 17737475.8
(22) Anmeldetag: 27.06.2017
(51) Int. Cl.: F16J 15/06, H05K 9/00

(54) **DICHTUNGSELEMENT ZUR FLUIDDICHTEN UND ELEKTRISCH LEITENDEN VERBINDUNG EINES ERSTEN BAUTEILS UND EINES ZWEITEN BAUTEILS SOWIE ENTSPRECHENDE BAUTEILANORDNUNG**
SEAL ELEMENT FOR CONNECTING A FIRST COMPONENT AND A SECOND COMPONENT IN A FLUID-TIGHT AND ELECTRICALLY CONDUCTIVE MANNER, AND CORRESPONDING COMPONENT ASSEMBLY
ÉLÉMENT D'ÉTANCHÉITÉ POUR LA LIAISON ÉTANCHE AU FLUIDE ET ÉLECTRO-CONDUCTRICE D'UNE PREMIÈRE PIÈCE ET D'UNE DEUXIÈME PIÈCE, AINSI QU'ENSEMBLE CORRESPONDANT DE PIÈCES

(30) Priorität: 25.07.2016 DE 102016213600
(43) Veröffentlichungstag der Anmeldung: 29.05.2019
(73) Patentinhaber: AUDI AG, 85045 Ingolstadt (DE)
(72) Erfinder: WEGSCHEIDER, Roland, 84048 Mainburg (DE); HENSEL, Manfred, 90530 Wendelstein (DE)
(86) Internationale Anmeldenummer: PCT/EP2017/000752
(87) Internationale Veröffentlichungsnummer: WO 2018/019400

(56) Entgegenhaltungen:
- DE-U- 7 437 558
- GB-A- 2 285 448
- US-A- 4 864 076

## Beschreibung

Die Erfindung betrifft ein Dichtungselement zur fluiddichten und elektrisch leitenden Verbindung eines ersten Bauteils und eines zweiten Bauteils. Die Erfindung betrifft weiterhin eine entsprechende Bauteilanordnung, welche das erste Bauteil, das zweite Bauteil sowie das Dichtungselement aufweist.

Das Dichtungselement wird beispielsweise während einer Montage sowohl an dem ersten Bauteil als auch an dem Bauteil anliegend angeordnet. Insbesondere liegt es nach der Montage zwischen dem ersten Bauteil und dem zweiten Bauteil vor, bevorzugt ist es klemmend zwischen ihnen gehalten. Das Dichtungselement dient einerseits der fluiddichten Verbindung des ersten Bauteils mit dem zweiten Bauteil beziehungsweise umgekehrt. Das bedeutet, dass das Dichtungselement ein Hindurchtreten von Fluid, insbesondere von Feuchtigkeit, zwischen dem ersten Bauteil und dem zweiten Bauteil hindurch unterbindet, insbesondere also ein Eindringen des Fluids oder ein Austreten des Fluids.

Das erste Bauteil und das zweite Bauteil können grundsätzlich beliebig ausgestaltet sein. Beispielsweise liegen sie als Bestandteile eines Gehäuses vor, wobei das erste Bauteil als Grundkörper des Gehäuses und das zweite Bauteil als Deckel ausgestaltet sein kann. Selbstverständlich ist es auch möglich, dass das erste Bauteil beispielsweise als Maschinengehäuse und das zweite Bauteil als an dem Maschinengehäuse anzuordnender Stecker ausgebildet ist. In letzterem Fall ist das erste Bauteil beispielsweise das Maschinengehäuse einer elektrischen Maschine und das zweite Bauteil Bestandteil einer Kontakteinrichtung zur elektrischen Kontaktierung der elektrischen Maschine, beispielsweise zu deren Stromversorgung. In jedem Fall soll das Dichtungselement jedoch derart ausgestaltet und angeordnet sein, dass das Hindurchtreten von Fluid unterbunden wird.

Zusätzlich dient das Dichtungselement dem Herstellen der elektrisch leitenden Verbindung zwischen dem ersten Bauteil und dem zweiten Bauteil. Hierbei sind das erste Bauteil und das zweite Bauteil jeweils wenigstens bereichsweise elektrisch leitfähig, sodass ein elektrisch leitender Bereich des ersten Bauteils über das Dichtungselement elektrisch mit einem elektrisch leitenden zweiten Bereich des zweiten Bauteils verbindbar beziehungsweise nach der Montage verbunden ist. Durch das Herstellen der elektrisch leitenden Verbindung zwischen den beiden Bauteilen wird eine EMV-feste Verbindung (EMV: Elektromagnetische Verträglichkeit) geschaffen Somit wird ein Hindurchtreten, also beispielsweise ein Eintreten oder ein Austreten, von elektromagnetischer Strahlung durch das Dichtungselement beziehungsweise zwischen dem ersten Bauteil und dem zweiten Bauteil hindurch effektiv unterbunden.

Derartige Dichtungselemente sind häufig mehrteilig ausgestaltet, sodass zum einen bei der Fertigung und zum anderen bei der Montage ein hoher Arbeitsaufwand und entsprechend hohe Kosten anfallen. Insbesondere ist bei der Herstellung eine Nachbearbeitung der Dichtungselemente notwendig, um eine ausreichende Fluiddichtung und elektrisch leitende Verbindung mittels des Dichtungselements sicherzustellen. Aus diesem Grund ist es das Ziel, die Anzahl an Bauteilen zu reduzieren.

Beispielsweise ist aus der Druckschrift Dichtungselement DE 43 40 108 C3 ein Abschirmelement zur Vergrößerung der elektromagnetischen Verträglichkeit von elektrischen oder elektronischen Funktionsgruppen bekannt, welche mindestens teilweise von elektrisch leitenden, abschirmenden Gehäusewandungen umgeben sind oder Leiterplatten enthalten, welche elektrisch leitende abschirmende Bereiche aufweisen, wobei das Abschirmelement aus einem leisten- oder rahmenförmigen, starren Trägerelement aus Kunststoff besteht, welches mindestens eine aus leitfähigem Material unmittelbar auf einer seiner Oberflächen aufdispensierte kompressible oder elastische Schicht aufweist und zur dichtenden leitenden Überbrückung zwischen den abschirmenden Bereichen der Leiterplatten oder Gehäusewandungen angeordnet ist.

GB 2 285 448 offenbart ein Dichtungselement zur fluiddichten und elektrisch leitenden Verbindung eines ersten Bauteils und eines zweiten Bauteils, wobei das Dichtungselement ein elektrisch leitendes Trägerelement aufweist, wobei sich ausgehend von einer ersten Kontaktfläche und einer zweiten Kontaktfläche jeweils wenigstens eine einstückig mit dem Trägerelement ausgebildete Federzunge in die der jeweils anderen Kontaktfläche abgewandte Richtung erstreckt, und wobei an einem Hauptdichtungsbereich einerseits ein erster Hauptdichtungsteil einer elastischen Dichtungshülle mit einer ersten Hauptdichtungsfläche zur dichtenden Anlage an dem ersten Bauteil und andererseits ein zweiter Hauptdichtungsteil der Dichtungshülle mit einer zweiten Hauptdichtungsfläche zur dichtenden Anlage an dem zweiten Bauteil anliegt.

Es ist Aufgabe der Erfindung, ein Dichtungselement zur fluiddichten und elektrisch leitenden Verbindung eines ersten Bauteils und eines zweiten Bauteils vorzuschlagen, welches gegenüber bekannten Dichtungselementen Vorteile aufweist, insbesondere mit geringerem Aufwand herstellbar und montierbar ist.

Dies wird erfindungsgemäß mit einem Dichtungselement mit den Merkmalen des Anspruchs 1 erreicht. Dabei ist vorgesehen, dass das Dichtungselement ein elektrisch leitendes Trägerelement mit einem Haltebereich und einem bezüglich des Haltebereichs angewinkelten Hauptdichtungsbereich aufweist, wobei der Haltebereich einerseits eine erste Kontaktfläche zur Kontaktierung des ersten Bauteils und andererseits eine zweite Kontaktfläche zur Kontaktierung des zweiten Bauteils aufweist, wobei sich ausgehend von der ersten Kontaktfläche und der zweiten Kontaktfläche jeweils wenigstens eine einstückig mit dem Trägerelement ausgebildete Federzunge in die der jeweils anderen Kontaktfläche abgewandte Richtung erstreckt, und wobei an dem Hauptdichtungsbereich einerseits ein erster Hauptdichtungsteil einer elastischen Dichtungshülle mit einer ersten Hauptdichtungsfläche zur dichtenden Anlage an dem ersten Bauteil und andererseits ein zweiter Hauptdichtungsteil der Dichtungshülle mit einer zweiten Hauptdichtungsfläche zur dichtenden Anlage an dem zweiten Bauteil anliegt. Das Dichtungselement weist insoweit zwei wesentliche Bestandteile auf, nämlich das Trägerelement und die Dichtungshülle. Das Trägerelement besteht aus einem elektrisch leitenden beziehungsweise elektrisch leitfähigen Material und ist vorzugsweise einstückig ausgebildet. Als Material kommt beispielsweise Metall zum Einsatz, insbesondere Stahl, beispielsweise Federstahl. Das Trägerelement weist den Haltebereich und den Hauptdichtungsbereich auf, welche gegeneinander angewinkelt sind. Darunter ist zu verstehen, dass in einem Schnitt durch das Dichtungselement der Haltebereich beispielsweise von einer ersten Geraden definiert ist beziehungsweise diese in sich aufnimmt, während der Hauptdichtungsbereich von einer zweiten Geraden definiert ist beziehungsweise diese in sich aufnimmt.

Der Haltebereich und der Hauptdichtungsbereich beziehungsweise die beiden Geraden schließen nun miteinander einen Winkel ein, welcher größer als 0° und kleiner als 180° ist. Insbesondere liegt der Winkel in dem Bereich von 45° bis 135°, von 60° bis 120°, von 70° bis 110°, von 80° bis 100° oder beträgt in etwa oder genau 90°. Der Haltebereich und der Hauptdichtungsbereich sind vorzugsweise einstückig und/oder materialeinheitlich ausgestaltet, bestehen also in letzterem Fall aus demselben Material.

Der Haltebereich weist einerseits die erste Kontaktfläche und andererseits die zweite Kontaktfläche auf. Die beiden Kontaktflächen liegen vorzugsweise auf einander gegenüberliegenden Seiten des Haltebereichs vor. Besonders bevorzugt sind die beiden Kontaktflächen parallel zueinander angeordnet. Beispielsweise ist der Haltebereich stegartig ausgestaltet, wobei die beiden Kontaktflächen über eine, vorzugsweise durchgehende, Stirnfläche des Stegs miteinander verbunden sind, während der Haltebereich auf seiner der Stirnseite gegenüberliegenden Seite in den Hauptdichtungsbereich übergeht. Es kann vorgesehen sein, dass der Haltebereich und der Hauptdichtungsbereich unter einem Stoßwinkel, insbesondere dem vorstehend beschriebenen Winkel zwischen dem Haltebereich und dem Hauptdichtungsbereich, aufeinander treffen. Alternativ kann der Übergang zwischen dem Haltebereich und dem Hauptdichtungsbereich über eine Rundung realisiert sein, um Materialspannungen zu verringern. Die Rundung ist dabei vorzugsweise dem Hauptdichtungsbereich zugeordnet.

Die erste Kontaktfläche des Haltebereichs dient der Kontaktierung des ersten Bauteils; die zweite Kontaktfläche ist dagegen zur Kontaktierung des zweiten Bauteils vorgesehen. Zumindest eine der Kontaktflächen, vorzugsweise beide der Kontaktflächen, können nach der Montage des Dichtungselements und der beiden Bauteile wenigstens bereichsweise an dem jeweiligen Bauteil anliegen. Sie kann jedoch auch von dem jeweiligen Bauteil beabstandet angeordnet sein, insbesondere parallel zu einer entsprechenden Gegenkontaktfläche des Bauteils angeordnet sein.

Zur elektrischen Kontaktierung des ersten Bauteils und des zweiten Bauteils durch das Dichtungselement zur elektrisch leitenden Verbindung der beiden Bauteile sind die Federzungen vorgesehen, wobei jede der Kontaktflächen wenigstens eine dieser Federzungen zugeordnet ist. Es erstreckt sich also eine der Federzungen ausgehend von der ersten Kontaktfläche in die der zweiten Kontaktfläche abgewandte Richtung, insbesondere also - nach der Montage - in Richtung des ersten Bauteils. Die der zweiten Kontaktfläche zugeordnete. Federzunge erstreckt sich hingegen ausgehend von der zweiten Kontaktfläche in die der ersten Kontaktfläche abgewandte Richtung, insbesondere also - nach der Montage - in Richtung des zweiten Bauteils.

Die Federzungen sind derart ausgestaltet und angeordnet, dass sie nach der Montage des Dichtungselements an dem ersten Bauteil und dem zweiten Bauteil anliegen. Über die Federzungen und das Trägerelement ist insoweit nach der Montage die elektrisch leitende Verbindung der beiden Bauteile sichergestellt. Die Federzunge beziehungsweise die Federzungen sind einstückig mit dem Trägerelement ausgebildet. Zudem sind sie bevorzugt materialeinheitlich mit dem Trägerelement ausgestaltet, bestehen also ebenfalls aus dem elektrisch leitenden Material des Trägerelements.

Während der Montage des Dichtungselements beziehungsweise der beiden Bauteile werden die Federzungen in die Richtung der jeweils anderen Kontaktfläche federnd ausgelenkt, sodass sie von der hierdurch bewirkten Federkraft in Richtung des jeweiligen Bauteils beziehungsweise an dieses gedrängt werden. Auf diese Art und Weise ist über die Lebensdauer der Verbindung der beiden Bauteile eine zuverlässige elektrisch leitende Verbindung sichergestellt. Aufgrund der federnden Auslenkung der Federzungen während der Montage können diese zudem einen Abrieb des jeweiligen Bauteils bewirken. Hierdurch kann eine Beschichtung des Bauteils, beispielsweise eine durch Oxidierung entstandene Oxidschicht, aufgebrochen und die elektrische Anbindung der Federzunge an das jeweilige Bauteil verbessert werden. Beispielsweise verfügt die Federzunge hierzu über eine dem jeweiligen Bauteil zugewandte Kante, insbesondere eine scharfe Kante, welche beispielsweise einen Grad, vorzugsweise einen Stanzgrat, aufweist.

Der Hauptdichtungsbereich des Trägerelements dient dem Halten der Dichtungshülle, welche den Hauptdichtungsbereich und mithin das Trägerelement bereichsweise übergreift. Die Dichtungshülle weist die erste Hauptdichtungsfläche und die zweite Hauptdichtungsfläche auf. Die erste Hauptdichtungsfläche ist nach der Montage dem ersten Bauteil zugewandt und liegt an diesem dichtend an. Entsprechendes gilt für die zweite Hauptdichtungsfläche und das zweite Bauteil. Die Dichtungshülle ist vorzugsweise einstückig ausgebildet, sodass die beiden Hauptdichturigsflächen ebenfalls einstückig und bevorzugt zusätzlich materialeinheitlich ausgebildet sind. Beispielsweise ist die Dichtungshülle über den Hauptdichtungsbereich des Trägerelements übergestülpt, auf diesen aufgespritzt oder an diesen angespritzt. Grundsätzlich kann die Dichtungshülle jedoch auf beliebige Art und Weise auf das Trägerelement aufgebracht, insbesondere an diesem befestigt werden.

Das beschriebene Dichtungselement ermöglicht auf die beschriebene Art und Weise das Herstellen der fluiddichten und elektrisch leitenden Verbindung zwischen den beiden Bauteilen. Aufgrund der Federzunge wird eine zuverlässige elektrische Verbindung zwischen den Bauteilen sichergestellt. Durch die federnde Auslenkung der Federzunge und den hierdurch bewirkten Abrieb der Bauteile verbessert zudem die elektrische Anbindung des Dichtungselements an die beiden Bauteile.

Eine weitere Ausgestaltung der Erfindung sieht vor, dass die erste Kontaktfläche und die zweite Kontaktfläche jeweils in einer Ebene liegen, wobei die Ebenen parallel zueinander verlaufen. Hierauf wurde vorstehend bereits hingewiesen. Die erste Kontaktfläche wird beispielsweise von einer ersten Ebene und die zweite Kontaktfläche von einer zweiten Ebene definiert. Hierzu sind die beiden Kontaktflächen plan beziehungsweise eben ausgestaltet. Die beiden Ebenen sind nun parallel beabstandet voneinander angeordnet.

Eine Weiterbildung der Erfindung sieht vor, dass die Federzungen als Stanzzungen ausgebildet sind, wobei das Stanzen der Federzungen derart erfolgt, dass an einem freien Ende der Federzungen ein Stanzgrat vorliegt, der der jeweiligen Kontaktfläche abgewandt ist. Es wurde bereits erläutert, dass die Federzungen vorteilhafterweise eine scharfe Kante aufweisen, welche durch Ausbilden des Stanzgrats realisiert sein kann. Die Federzungen werden insoweit durch Stanzen des Trägerelements ausgebildet.

Das Stanzen wird dabei derart ausgeführt, insbesondere wird die Stanzrichtung derart gewählt, dass der durch das Stanzen entstehende Stanzgrat an dem freien Ende der jeweiligen Federzunge ausgebildet wird und der jeweiligen Kontaktfläche abgewandt ist. Der Stanzgrat soll also nach der Montage in Richtung des jeweiligen Bauteils weisen und bei der Montage mit diesem in Anlagekontakt geraten, sodass der scharfe Stanzgrat den Abrieb bewirkt, welcher wiederum die elektrische Verbindung zwischen den Bauteilen verbessert.

Im Rahmen einer bevorzugten Ausführungsform der Erfindung ist vorgesehen, dass die Federzungen einen zu den Kontaktflächen parallelen Bereich und einen bezüglich den Kontaktflächen angewinkelten Bereich aufweisen. Beispielsweise schließt sich der parallele Bereich an die Kontaktflächen an, während der angewinkelte Bereich von den Kontaktflächen beanstandet ist. Insbesondere ist also der angewinkelte Bereich der Federzunge über den jeweiligen parallelen Bereich mit der entsprechenden Kontaktfläche verbunden. Durch eine derartige Ausgestaltung wird die abrasive Wirkung der Federzunge auf die Bauteile bei gleichzeitigem Sicherstellen einer ausreichenden Federwirkung verbessert, weil der Winkel zwischen dem angewinkelten Bereich und den Bauteilen vergleichsweise steil gewählt werden kann. Beispielsweise schließen der parallele Bereich und der angewinkelte Bereich einen Winkel ein, der größer als 0° und kleine als 180° ist. Bevorzugt ist der Winkel ein stumpfer Winkel, ist also größer als 90°, sodass ein freies Ende des angewinkelten Bereichs von dem parallelen Bereich fortweist.

Eine weitere Ausgestaltung der Erfindung sieht vor, dass das Trägerelement ringförmig ist, sodass der Haltebereich eine Durchtrittsöffnung randgeschlossen umfasst. Unter der ringförmigen Ausgestaltung des Trägerelements ist dabei eine Ausgestaltung der Gestalt zu verstehen, dass das Trägerelement in einer Richtung durchgehend verläuft, sodass es eine durchgehende Randkante aufweist. Diese Randkante umgreift beispielsweise die Durchtrittsöffnung, welche insoweit von dem Trägerelement umschlossen ist. Die Randkante liegt beispielsweise an der vorstehend bereits erwähnten Stirnseite des Haltebereichs vor.

Das Trägerelement, insbesondere der Haltebereich, ist beispielsweise rund, oval oder stadionförmig ausgestaltet. Unter letzterem ist eine Gestalt zu verstehen, welche im Schnitt gesehen von zwei parallelen geraden Linien sowie zwei die beiden Linien endseitig verbindenden gekrümmten Linien begrenzt ist. Die gekrümmten Linien sind beispielsweise teilkreisförmig, insbesondere halbkreisförmig und laufend bevorzugt jeweils beidseitig tangential in die entsprechende gerade Linie ein.

Eine Weiterbildung der Erfindung kann vorteilhafterweise vorsehen, dass die erste Hauptdichtungsfläche und/oder die zweite Hauptdichtungsfläche jeweils zumindest bereichsweise von wenigstens einer Dichtlippe gebildet sind, die sich in eine der jeweils anderen Hauptdichtungsfläche abgewandte Richtung erstreckt. Die Dichtlippe dient der Verbesserung der Dichtwirkung der Dichtungshülle. Vorzugsweise ist an jeder der Hauptdichtungsflächen jeweils eine derartige Dichtlippe angeordnet. Vorzugsweise ist an den beiden Hauptdichtungsflächen jeweils dieselbe Anzahl an Dichtlippen vorgesehen. Beispielsweise liegen an der ersten Hauptdichtungsfläche und/oder der zweiten Hauptdichtungsfläche jeweils mehrere Dichtlippen vor, insbesondere also mindestens zwei Dichtlippen, mindestens drei Dichtlippen oder mindestens vier Dichtlippen.

Eine bevorzugt Weiterbildung der Erfindung sieht vor, dass das Trägerelement einen Vordichtungsbereich aufweist, der sich auf der dem Haltebereich abgewandten Seite an den Hauptdichtungsbereich anschließt, wobei der Vordichtungsbereich bezüglich des Hauptdichtungsbereichs angewinkelt ist, insbesondere parallel zu dem Haltebereich angeordnet ist, und wobei an dem Vordichtungsbereich einerseits ein erster Vordichtungsteil der Dichtungshülle mit einer ersten Vordichtungsfläche zur dichtenden Anlage an dem ersten Bauteil und andererseits ein zweiter Vordichtungsteil der Dichtungshülle mit einer zweiten Vordichtungsfläche zur dichtenden Anlage an dem zweiten Bauteil anliegt.

Zusätzlich zu dem Hauptdichtungsbereich liegt insoweit der Vordichtungsbereich vor. Der Vordichtungsbereich ist über den Hauptdichtungsbereich an den Haltebereich des Trägerelements angebunden. Bevorzugt ist auch der Vordichtungsbereich einstückig und/oder materialeinheitlich mit dem Hauptdichtungsbereich beziehungsweise dem Haltebereich ausgebildet. Der Vordichtungsbereich ist bezüglich des Hauptdichtungsbereichs angewinkelt. Hierbei ist der Vordichtungsbereich von einer Ebene definiert beziehungsweise liegt in dieser, die bezüglich der den Hauptdichtungsbereich der definierenden Ebene unter einem Winkel vorliegt, welcher größer als 0° und kleiner als 180° ist. Vorzugsweise beträgt der Winkel zwischen dem Hauptdichtungsbereich und dem Vordichtungsbereich von 60° bis 120°, von 70° bis 110°, von 80° bis 100° oder in etwa oder genau 90°. Beispielsweise ist der Vordichtungsbereich parallel zu dem Haltebereich angeordnet. Die Dichtungshülle liegt nun nicht nur an dem Hauptdichtungsbereich, sondern zusätzlich an dem Vordichtungsbereich vor. Hinsichtlich den Vordichtungsbereichen und den Vordichtungsflächen wird auf die Ausführungen zu dem Hauptdichtungsbereich und den Haüptdichtungsflächen hingewiesen, welche analog herangezogen werden können.

Schließlich kann im Rahmen einer vorteilhaften Ausgestaltung der Erfindung vorgesehen sein, dass die Dichtungshülle im Schnitt gesehen ein im Haltebereich abgewandtes freies Ende des Trägerelements umgreift, sodass die Dichtungshülle die erste Hauptdichtungsfläche und die zweite Hauptdichtungsfläche und/oder die erste Vordichtungsfläche und die zweite Vordichtungsfläche ausbildet. Das freie Ende ist Bestandteil des Hauptdichtungsbereichs oder - sofern der Vordichtungsbereich vorgesehen ist - des Vordichtungsbereichs. Die Dichtungshülle ist nun derart ausgestaltet, dass zumindest die erste Hauptdichtungsfläche und die zweite Hauptdichtungsfläche und optional die erste Vordichtungsfläche und die zweite Vordichtungsfläche einstückig und/oder materialeinheitlich miteinander ausgestaltet sind. Hierdurch wird eine besonders hohe Dichtwirkung des Dichtungselements realisiert.

Die Erfindung betrifft weiterhin eine Bauteilanordnung, mit einem ersten Bauteil, einem zweiten Bauteil sowie einem Dichtungselement zur fluiddichten und elektrisch leitenden Verbindung des ersten Bauteils und des zweiten Bauteils, insbesondere mit einem Dichtungselement gemäß den vorstehenden Ausführungen.

Dabei ist vorgesehen, dass das Dichtungselement ein elektrisch leitendes Trägerelement mit einem Haltebereich und einem bezüglich des Haltebereichs angewinkelten Hauptdichtungsbereich aufweist, wobei der Haltebereich einerseits eine erste Kontaktfläche zur Kontaktierung des ersten Bauteils und andererseits eine zweite Kontaktfläche zur Kontaktierung des zweiten Bauteils aufweist, wobei sich ausgehend von der ersten Kontaktfläche und der zweiten Kontaktfläche jeweils wenigstens eine einstückig mit dem Trägerelement ausgebildete Federzunge in die der jeweils anderen Kontaktfläche abgewandte Richtung erstreckt, und wobei an dem Hauptdichtungsbereich einerseits ein erster Hauptdichtungsteil einer elastischen Dichtungshülle mit einer ersten Hauptdichtungsfläche zur dichtenden Anlage an dem ersten Bauteil und andererseits ein zweiter Hauptdichtungsteil der Dichtungshülle mit einer zweiten Hauptdichtungsfläche zu dichtenden Anlage an einem zweiten Bauteil anliegt.

Auf die Vorteile einer derartigen Ausgestaltung der Bauteilanordnung beziehungsweise des Dichtungselements wurde bereits hingewiesen. Sowohl die Bauteilanordnung als auch das Dichtungselement können gemäß den vorstehenden Ausführungen weitergebildet sein, sodass insoweit auf diese verwiesen wird.

Es kann im Rahmen einer weiteren Ausgestaltung der Erfindung vorgesehen sein, dass das erste Bauteil eine Aufnahmeöffnung aufweist, in der das zweite Bauteil und das Dichtungselement jeweils zumindest bereichsweise angeordnet sind, wobei das Dichtungselement zwischen dem ersten Bauteil und dem zweiten Bauteil klemmend gehalten ist. Das zweite Bauteil ist dabei beispielsweise als Verschluss für die Aufnahmeöffnung und insoweit als Deckel für das erste Bauteil ausgestaltet. Das Dichtungselement soll nach der Montage der Bauteilanordnung zwischen dem ersten Bauteil und einem zweiten Bauteil vorliegen und dabei an beiden derart anliegen, dass diese zum einem elektrisch miteinander verbunden sind und zum anderen gegeneinander abgedichtet sind.

Die Erfindung wird nachfolgend anhand der in der Zeichnung dargestellten Ausführungsbeispiele näher erläutert, ohne dass eine Beschränkung der Erfindung erfolgt. Dabei zeigt:
- Figur 1: eine schematische Schnittdarstellung durch eine Bauteilanordnung, welche ein erstes Bauteil, ein zweites Bauteil sowie ein Dichtungselement aufweist, und
- Figur 2: eine schematische Detaildarstellung des Dichtungselements, welches ein Trägerelement sowie eine Dichtungshülle aufweist.

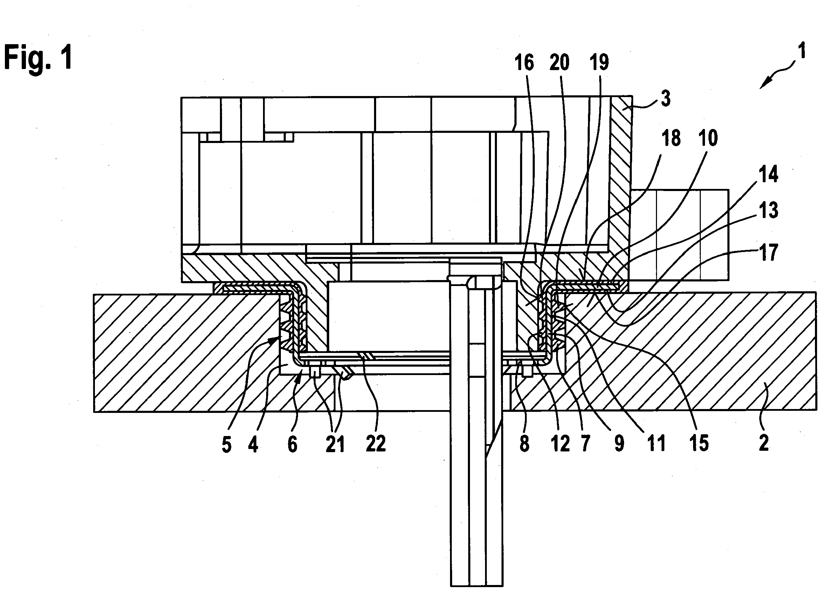

Die Figur 1 zeigt eine Schnittdarstellung durch einen Bereich einer Bauteilanordnung 1, welche über ein erstes Bauteil 2 und ein zweites Bauteil 3 verfügt. Das erste Bauteil 2 weist eine Aufnahmeöffnung 4 auf, in welche das zweite Bauteil 3 bereichsweise eingreift. Zur fluiddichten und elektrisch leitenden Verbindung der beiden Bauteile 2 und 3 miteinander verfügt die Bauteilanordnung 1 über ein Dichtungselement 5. Dieses weist ein Trägerelement 6 aus einem elektrisch leitenden Material sowie eine Dichtungshülle 7 auf, die das Trägerelement 6 bereichsweise umgreift beziehungsweise an diesem befestigt ist. Die Dichtungshülle 7 besteht bevorzugt aus einem flexiblen Dichtungsmaterial.

Das Trägerelement 6 weist in dem hier dargestellten Ausführungsbeispiel mehrere Bereiche, nämlich einen Haltebereich 8, einen Hauptdichtungsbereich 9 sowie einen Vordichtungsbereich 10 auf. Der Hauptdichtungsbereich 9 ist bezüglich des Haltebereichs 8 und der Vordichtungsbereichs 10 jeweils angewinkelt. Dabei sind der Haltebereich 8 und der Vordichtungsbereich 10 bevorzugt derart angeordnet, dass sie - im Schnitt gesehen - parallel zueinander angeordnet sind, sich jedoch ausgehend von dem Hauptdichtungsbereich 9 in entgegengesetzte Richtungen erstrecken.

Die Dichtungshülle 7 weist einen ersten Hauptdichtungsteil 11, einen zweiten Hauptdichtungsteil 12, einen ersten Vordichtungsteil 13 und einen zweiten Vordichtungsteil 14 auf. Die Hauptdichtungsteile 11 und 12 sind auf gegenüberliegenden Seiten des Hauptdichtungsbereichs 9 und die Vordichtungsteile 13 und 14 auf gegenüberliegenden Seiten des Vordichtungsbereichs 10 des Trägerelements 6 angeordnet. Der erste Hauptdichtungsteil 11 und der erste Vordichtungsteil 13 sind zum dichtenden Anliegen an dem ersten Bauteil 2, der zweite Hauptdichtungsteil 12 und der zweite Vordichtungsteil 14 zum dichtenden Anliegen an dem zweiten Bauteil 3 vorgesehen.

Der erste Hauptdichtungsteil 11 liegt mit einer ersten Hauptdichtungsfläche 15, der zweite Hauptdichtungsteil 12 mit einer zweiten Hauptdichtungsfläche 16, der erste Vordichtungsteil 13 mit einer Vordichtungsfläche 17 und der zweite Vordichtungsteil 14 mit einer zweiten Vordichtungsfläche 18 an dem jeweiligen Bauteil 2 beziehungsweise 3 an. Die Hauptdichtungsflächen 15 und 16 werden dabei wenigstens bereichsweise von Dichtlippen 19 und 20 gebildet beziehungsweise liegen an diesen vor, welche von dem jeweiligen Hauptdichtungsteil 11 beziehungsweise 12 ausgehen. Die Dichtungshülle 7 stellt mit ihren Hauptdichtungsteilen 11 und 12 sowie ihren Vordichtungsteilen 13 und 14 eine fluiddichte Verbindung zwischen den Bauteilen 2 und 3 sicher.

Der Haltebereich 8 der Trägerelements 6 verfügt über Federzungen 21 und 22, wobei die wenigstens eine Federzunge 21, vorzugsweise mehrere Federzungen 21, in Richtung des ersten Bauteils 2 und die wenigstens eine Federzunge 22, vorzugsweise mehrere Federzungen 22, in Richtung des zweiten Bauteils 3 ragen. Die Federzungen 21 und 22 sind hier lediglich exemplarisch angedeutet. Die Federzungen 21 und 22 sind bevorzugt einstückig und/oder materialeinheitlich mit dem Trägerelement 6 ausgebildet. Entsprechend bestehen sie ebenfalls aus dem elektrisch leitfähigen Material, sodass über die Federzungen 21 und 22 sowie das Trägerelement 6 beziehungsweise dessen Haltebereich 8 die elektrische Verbindung zwischen den Bauteilen 2 und 3 hergestellt ist.

Es ist zu erkennen, dass die wenigstens eine Federzunge 21 an einem nicht näher bezeichneten Grund der Aufnahmeöffnung 4 anliegt, während die Federzunge 22 an einer ebenfalls nicht näher bezeichneten Stirnseite des zweiten Bauteils 3 angreift. Bevorzugt ist zudem der Vordichtungsbereich 10 zusammen mit den Vordichtungsteilen 13 und 14 der Dichtungshülle 7 zwischen den Bauteilen 2 und 3 klemmend gehalten, sodass eine Verlagerung des Dichtungselements 5 unterbunden ist.

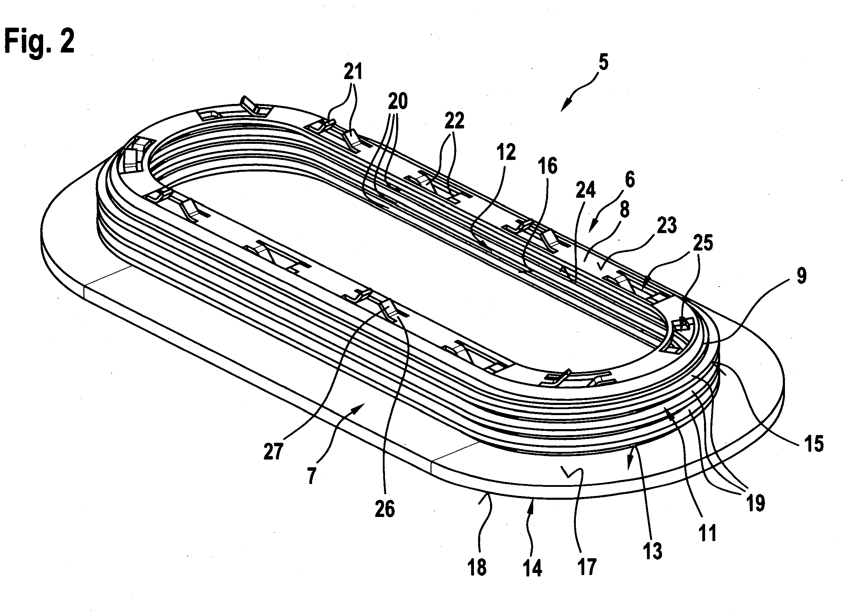

Die Figur 2 zeigt eine Detaildarstellung des Dichtungselements 5. Grundsätzlich wird auf die vorstehenden Ausführungen verwiesen. Erkennbar ist hier, dass eine erste Kontaktfläche 23 des Haltebereichs 8 sowie eine ihr gegenüberliegende zweite Kontaktfläche 24 plan sind. In den Kontaktflächen 23 und 24 sind Öffnungen 25, insbesondere Stanzöffnungen 25, ausgebildet, in welchen jeweils zwei Federzungen 21 und/oder 22 ausgebildet sind. Die Federzungen 21 und 22 liegen als Stanzzungen vor, welche durch Stanzen hergestellt sind. Jede der Federzungen 21 und 22 weist einen zu den Kontaktflächen 23 und 24 im Wesentlichen parallelen Bereich 26 sowie einen bezüglich des parallelen Bereichs 26 und mithin den Kontaktflächen 23 und 24 angewinkelten Bereich 27.

Der angewinkelte Bereich 27 ist über den parallelen Bereich 26 mit der Kontaktfläche 23 beziehungsweise 24 verbunden. Es ist deutlich erkennbar, dass in jeder Öffnung 25 mehrere dieser Federzungen 21 und/oder 22 angeordnet sind. Vorzugsweise sind in einer Öffnung 25 mehrere Federzungen 21, in einer anderen der Öffnungen 25 mehrere Federzungen 22 und in einer weiteren der Öffnungen 25 sowohl eine Federzunge 21 als auch eine Federzunge 22 angeordnet, welche insoweit in unterschiedliche Richtungen ragen. Die Öffnungen 25 können in Umfangsrichtung gleichmäßig verteilt in dem Haltebereich 8 ausgebildet sein. Auch eine ungleichmäßige Anordnung ist jedoch realisierbar.

Mit dem vorstehend beschriebenen Dichtungselement 5 ist eine zuverlässige und dauerhafte fluiddichte und elektrisch leitende Verbindung zwischen den Bauteilen 2 und 3 realisierbar. Aufgrund der Ausgestaltung der Federzungen 21 und 22 als Stanzzungen können diese zudem jeweils mit einem Stanzgrat versehen sein, welcher eine abrasive Wirkung auf die Bauteile 2 und 3 bei der Montage der Bauteilanordnung 1 hat. Durch diese abrasive Wirkung kann eine Beschichtung, insbesondere eine Oxidschicht oder dergleichen, der Bauteile 2 und 3 während der Montage der Bauteilanordnung 1 entfernt und entsprechend eine elektrisch gut leitende Verbindung zwischen den Bauteilen 2 und 3 hergestellt sein.

## Patentansprüche

1. Dichtungselement (5) zur fluiddichten und elektrisch leitenden Verbindung eines ersten Bauteils (2) und eines zweiten Bauteils (3), wobei, das Dichtungselement (5) ein elektrisch leitendes Trägerelement (6) mit einem Haltebereich (8) und einem bezüglich des Haltebereichs (8) angewinkelten Hauptdichtungsbereich (9) aufweist, wobei der Haltebereich (8) einerseits eine erste Kontaktfläche (23) zur Kontaktierung des ersten Bauteils (2) und andererseits eine zweite Kontaktfläche (24) zur Kontaktierung des zweiten Bauteil (3) aufweist, wobei sich ausgehend von der ersten Kontaktfläche (23) und der zweiten Kontaktfläche (24) jeweils wenigstens eine einstückig mit dem Trägerelement (6) ausgebildete Federzunge (21,22) in die der jeweils anderen Kontaktfläche (23,24) abgewandte Richtung erstreckt, und wobei an dem Hauptdichtungsbereich (9) einerseits ein erster Hauptdichtungsteil (11) einer elastischen Dichtungshülle (7) mit einer ersten Hauptdichtungsfläche (15) zur dichtenden Anlage an dem ersten Bauteil (2) und andererseits ein zweiter Hauptdichtungsteil (12) der Dichtungshülle (7) mit einer zweiten Hauptdichtungsfläche (16) zur dichtenden Anlage an dem zweiten Bauteil (3) anliegt.

2. Dichtungselement nach Anspruch 1, **dadurch gekennzeichnet, dass** die erste Kontaktfläche (23) und die zweite Kontaktfläche (24) jeweils in einer Ebene liegen, wobei die Ebenen parallel zueinander verlaufen.

3. Dichtungselement nach einem der vorhergehenden Ansprüche, **dadurch gekennzeichnet, dass** die Federzungen (21,22) als Stanzzungen ausgebildet sind, wobei das Stanzen der Federzungen (21,22) derart erfolgt, dass an einem freien Ende der Federzungen (21,22) ein Stanzgrat vorliegt, der der jeweiligen Kontaktfläche (23,24) abgewandt ist.

4. Dichtungselement nach einem der vorhergehenden Ansprüche, **dadurch gekennzeichnet, dass** die Federzungen (21,22) einen zu den Kontaktflächen (23,24) parallelen Bereich (26) und einen bezüglich den Kontaktflächen (23,24) angewinkelten Bereich (27) aufweisen.

5. Dichtungselement nach einem der vorhergehenden Ansprüche, **dadurch gekennzeichnet, dass** das Trägerelement (6) ringförmig ist, sodass der Haltebereich (8) eine Durchtrittsöffnung randgeschlossen umfasst.

6. Dichtungselement nach einem der vorhergehenden Ansprüche, **dadurch gekennzeichnet, dass** die erste Hauptdichtungsfläche (15) und/oder die zweite Hauptdichtungsfläche (16) jeweils zumindest bereichsweise von wenigstens einer Dichtlippe (19,20) gebildet sind, die sich in eine der jeweils anderen Hauptdichtungsfläche (15,16) abgewandte Richtung erstreckt.

7. Dichtungselement nach einem der vorhergehenden Ansprüche, **dadurch gekennzeichnet, dass** das Trägerelement (6) einen Vordichtungsbereich (10) aufweist, der sich auf der dem Haltebereich (8) abgewandten Seite an den Hauptdichtungsbereich (9) anschließt, wobei der Vordichtungsbereich (10) bezüglich des Hauptdichtungsbereich (9) angewinkelt ist, insbesondere parallel zu dem Haltebereich (8) angeordnet ist, und wobei an dem Vordichtungsbereich (10) einerseits ein erster Vordichtungsteil (13) der Dichtungshülle (7) mit einer ersten Vordichtungsfläche (17) zur dichtenden Anlage an dem ersten Bauteil (2) und andererseits ein zweiter Vordichtungsteil (14) der Dichtungshülle (7) mit einer zweiten Vordichtungsfläche (18) zur dichtenden Anlage an dem zweiten Bauteil (3) anliegt.

8. Dichtungselement nach einem der vorhergehenden Ansprüche, **dadurch gekennzeichnet, dass** die Dichtungshülle (7) im Schnitt gesehen ein dem Haltebereich (8) abgewandtes freies Ende des Trägerelements (6) umgreift, sodass Dichtungshülle (7) die erste Hauptdichtungsfläche (15) und die zweite Hauptdichtungsfläche (16) und/oder die erste Vordichtungsfläche (17) und die zweite Vordichtungsfläche (18) ausbildet.

9. Bauteilanordnung (1), mit einem ersten Bauteil (2), einem zweiten Bauteil (3) sowie einem Dichtungselement (5) nach einem oder mehreren der vorhergehenden Ansprüche zur fluiddichten und elektrisch leitenden Verbindung des ersten Bauteils (2) und des zweiten Bauteils (3).

10. Bauteilanordnung nach Anspruch 9, **dadurch gekennzeichnet, dass** das erste Bauteil (2) eine Aufnahmeöffnung (4) aufweist, in der das zweite Bauteil (3) und das Dichtungselement (5) jeweils zumindest bereichsweise angeordnet sind, wobei das Dichtungselement (5) zwischen dem ersten Bauteil (2) und dem zweiten Bauteil (3) klemmend gehalten ist.

## Claims

1. Seal element (5) for connecting a first component (2) and a second component (3) in a fluid-tight and electrically conductive manner, wherein
the seal element (5) has an electrically conductive carrier element (6) with a retaining region (8) and a main sealing region (9) angled with respect to the retaining region (8), wherein the retaining region (8) has on the one side a first contact surface (23) for contacting the first component (2) and on the other side a second contact surface (24) for contacting the second component (3), wherein, starting from the first contact surface (23) and the second contact surface (24) in each case at least one spring tongue (21,22) formed integrally with the carrier element (6) extends in the direction facing away from the respectively other contact surface (23,24), and wherein on the main sealing region (9) on the one side a first main sealing part (11) of an elastic sealing sheath (7) having a first main sealing surface (15) for sealing abutment abuts on the first component (2) and on the other side a second main sealing parts (12) of the sealing sheath (7) with a second main sealing surface (16) for sealing abutment abuts on the second component (3).

2. Seal element according to claim 1, **characterised in that** the first contact surface (23) and the second contact surface (24) lie respectively on a plane, wherein the planes extend parallel to one another.

3. Seal element according to any of the preceding claims, **characterised in that** the spring tongues (21,22) are formed as punched tongues, wherein the punching of the spring tongues (21,22) takes place such that on a free end of the spring tongues (21,22) a punching burr is present which faces away from the respective contact surface (23,24).

4. Seal element according to any of the preceding claims, **characterised in that** the spring tongues (21,22) have a region (26) parallel to the contact surfaces (23,24) and a region (27) angled with respect to the contact surfaces (23,24).

5. Seal element according to any of the preceding claims, **characterised in that** the carrier element (6) is annular, such that the retaining region (8) encloses a through-opening in a closed-edged manner.

6. Seal element according to any of the preceding claims, **characterised in that** the first main sealing surface (15) and/or the second main sealing surface (16) are formed in each case at least partially by at least one sealing lip (19,20) which extends in a direction facing away from the respectively other main sealing surface (15,16).

7. Seal element according to any of the preceding claims, **characterised in that** the carrier element (6) has a pre-sealing region (10) which adjoins on the main sealing region (9) on the side facing away from the retaining region (8), wherein the pre-sealing region (10) is angled with respect to the main sealing region (9), in particular is disposed parallel to the retaining region (8), and wherein on the pre-sealing region (10) on the one side a first pre-sealing part (13) of the sealing sheath (7) abuts with a first pre-sealing surface (17) for sealing abutment on the first component (2) and on the other side a second pre-sealing part (14) of the sealing sheath (7) abuts with a second pre-sealing surface (18) for sealing abutment on the second component (3).

8. Seal element according to any of the preceding claims, **characterised in that** the sealing sheath (7) viewed from a cross-sectional point of view encloses a free end, facing away from the retaining region (8), of the carrier element (6), such that sealing sheath (7) forms the first main sealing surface (15) and the second main sealing surface (16) and/or the first pre-sealing surface (17) and the second pre-sealing surface (18).

9. Component assembly (1) with a first component (2), a second component (3) and a seal element (5) according to one or more of the preceding claims for the fluid-tight and electrically conductive connection of the first component (2) and the second component (3).

10. Component assembly according to claim 9, **characterised in that** the first component (2) has a receiving opening (4) in which the second component (3) and the seal element (5) are disposed at least partially in each case, wherein the seal element (5) is held clampingly between the first component (2) and the second component (3).

## Revendications

1. Élément d'étanchéité (5) pour la liaison étanche au fluide et électroconductrice d'une première pièce (2) et d'une seconde pièce (3), dans lequel,
l'élément d'étanchéité (5) présente un élément porteur (6) électro-conducteur avec une zone de retenue (8) et une zone d'étanchéité principale (9) coudée par rapport à la zone de retenue (8), dans lequel la zone de retenue (8) présente d'une part une première surface de contact (23) pour la mise en contact de la première pièce (2) et d'autre part une seconde surface de contact (24) pour la mise en contact de la seconde pièce (3), dans lequel respectivement au moins une languette de ressort (21,22) réalisée d'une seule pièce avec l'élément porteur (6) s'étend à partir de la première surface de contact (23) et de la seconde surface de contact (24) dans la direction opposée à l'autre surface de contact (23,24) respective, et dans lequel d'une part une première partie d'étanchéité principale (11) d'une enveloppe d'étanchéité élastique (7) avec une première surface d'étanchéité principale (15) destinée à prendre appui étanche sur la première pièce (2) et d'autre part une seconde partie d'étanchéité principale (12) de l'enveloppe d'étanchéité (7) avec une seconde surface d'étanchéité principale (16) destinée à prendre appui étanche sur la seconde pièce (3) s'appliquent contre la zone d'étanchéité principale (9).

2. Elément d'étanchéité selon la revendication 1, **caractérisé en ce que** la première surface de contact (23) et la seconde surface de contact (24) se situent respectivement dans un plan, dans lequel les plans s'étendent parallèlement l'un à l'autre.

3. Elément d'étanchéité selon l'une quelconque des revendications précédentes, **caractérisé en ce que** les languettes de ressort (21,22) sont réalisées en tant que languettes poinçonnées, dans lequel le poinçonnage des languettes de ressort (21,22) s'effectue de telle sorte qu'une bavure de poinçonnage, qui est opposée à la surface de contact (23,24) respective, est présente à une extrémité libre des languettes de ressort (21,22).

4. Elément d'étanchéité selon l'une quelconque des revendications précédentes, **caractérisé en ce que** les languettes de ressort (21,22) présentent une zone (26) parallèle aux surfaces de contact (23,24) et une zone (27) coudée par rapport aux surfaces de contact (23,24).

5. Elément d'étanchéité selon l'une quelconque des revendications précédentes, **caractérisé en ce que** l'élément porteur (6) est annulaire, de sorte que la zone de retenue (8) comprend une ouverture de passage fermée sur les bords.

6. Elément d'étanchéité selon l'une quelconque des revendications précédentes, **caractérisé en ce que** la première surface d'étanchéité principale (15) et/ou la seconde surface d'étanchéité principale (16) sont formées respectivement au moins par endroits par au moins une lèvre d'étanchéité (19,20), qui s'étend dans une direction opposée à l'autre surface d'étanchéité principale (15,16) respective.

7. Elément d'étanchéité selon l'une quelconque des revendications précédentes, **caractérisé en ce que** l'élément porteur (6) présente une zone de pré-étanchéité (10), qui se raccorde à la zone d'étanchéité principale (9) sur la face opposée à la zone de retenue (8), dans lequel la zone de pré-étanchéité (10) est coudée par rapport à la zone d'étanchéité principale (9), en particulier est disposée parallèlement à la zone de retenue (8), et dans lequel d'une part une première partie de pré-étanchéité (13) de l'enveloppe d'étanchéité (7) avec une première surface de pré-étanchéité (17) destinée à prendre appui étanche sur la première pièce (2) et d'autre part une seconde partie de pré-étanchéité (14) de l'enveloppe d'étanchéité (7) avec une seconde surface de pré-étanchéité (18) destinée à prendre appui étanche sur la seconde pièce (3) s'appliquent contre la zone de pré-étanchéité (10).

8. Elément d'étanchéité selon l'une quelconque des revendications précédentes, **caractérisé en ce que** l'enveloppe d'étanchéité (7), vue en coupe, enserre une extrémité libre de l'élément porteur (6) opposée à la zone de retenue (8), de sorte qu'enveloppe d'étanchéité (7) forme la première surface d'étanchéité principale (15) et la seconde surface d'étanchéité principale (16) et/ou la première surface de pré-étanchéité (17) et la seconde surface de pré-étanchéité (18).

9. Ensemble d'éléments (1), avec une première pièce (2), une seconde pièce (3) ainsi qu'un élément d'étanchéité (5) selon l'une ou plusieurs des revendications précédentes pour la liaison étanche au fluide et électroconductrice de la première pièce (2) et de la seconde pièce (3).

10. Ensemble d'éléments selon la revendication 9, **caractérisé en ce que** la première pièce (2) présente une ouverture de logement (4), dans laquelle la seconde pièce (3) et l'élément d'étanchéité (5) sont disposés respectivement au moins par endroits, dans lequel l'élément d'étanchéité (5) est retenu avec serrage entre la première pièce (2) et la seconde pièce (3).
